(19) Europäisches Patentamt
European Patent Office
Office européen des brevets

(11) **EP 1 890 379 A1**

(12) **EUROPEAN PATENT APPLICATION**
published in accordance with Art. 153(4) EPC

(43) Date of publication:
**20.02.2008 Bulletin 2008/08**

(21) Application number: **06711955.2**

(22) Date of filing: **19.01.2006**

(51) Int Cl.:
*H03H 3/02* [(2006.01)]     *H01L 41/22* [(2006.01)]
*H01L 21/302* [(2006.01)]     *H01L 41/09* [(2006.01)]
*H03H 9/17* [(2006.01)]     *B81C 1/00* [(2006.01)]

(86) International application number:
**PCT/JP2006/300709**

(87) International publication number:
**WO 2006/080226 (03.08.2006 Gazette 2006/31)**

(84) Designated Contracting States:
**DE GB NL**

(30) Priority: **28.01.2005   JP 2005020616**

(71) Applicant: **Sony Corporation**
**Minato-ku**
**Tokyo (JP)**

(72) Inventors:
• **OSAKA, Tsutomu**
**c/o Sony Corporation**
**Tokyo (JP)**

• **SATO, Susumu**
**Tokyo (JP)**

(74) Representative: **Körber, Martin Hans**
**Mitscherlich & Partner**
**Patent- und Rechtsanwälte**
**Postfach 33 06 09**
**80066 München (DE)**

(54) **PROCESS FOR PRODUCING MICROMACHINE, AND MICROMACHINE**

(57)     A method of manufacturing a micromachine in which corrosion of a structure is restrained and the micromachine are provided. The method of manufacturing a micromachine includes a first step of patterningly forming a sacrificial layer 12 having a silicon oxide based material containing a hydrogen fluoride dissociating species on a substrate 11, a second step of forming a structure 16 on the substrate 11 in the state of covering the sacrificial layer 12, a third step of forming the structure 16 on the sacrificial layer 12 with a hole part or parts 18 reaching the sacrificial layer 12, and a fourth step of forming a vibrating space between the substrate 11 and the structure 16 by introducing only a hydrogen fluoride gas or only the hydrogen fluoride gas and an inert gas through the hole part or parts 18 and etching the sacrificial layer 12 by use of the dissociating species contained in the sacrificial layer 12. The micromachine is manufactured by the method.

# FIG.1(a)

EP 1 890 379 A1

# FIG.1(b)

# FIG.1(c)

# FIG.1(d)

**Description**

Technical Field

The present invention relates to a method of manufacturing a micromachine used as a filter in an electronic apparatus or communication apparatus and the micromachine, and particularly to a thin film bulk acoustic wave resonator (FBAR).

Background Art

As an element to be used in such circuits as a transmission filter and a duplexer constituting a wireless communication system, such as a portable phone, or a wireless sensing system, the FBAR excellent in highfrequency filter characteristics and enabling a reduction in apparatus size has been being paid attention to in recent years.

The structures of the FBAR and the methods of manufacturing the same which are known include (1) substrate face side processing system, (2) substrate back side via system, (3) air bridge system, and (4) multilayer acoustic mirror system. Among these systems, the basic structures in other systems than the multilayer acoustic mirror system have air layers are provided on the upper and lower sides of a vibrating part. Among others, the air bridge system enables simplification of the complicated steps in the manufacturing method and, hence, it is expected as a method in which a reduction in cost can be promised and the FBAR can be mixedly mounted together with an integrated circuit.

In the FBAR of the air bridge system, a structure having a lower electrode film, a piezoelectric film, an upper electrode film sequentially layered is formed over a substrate, with an air layer, or vibrating space (also called cavity), therebetween. The region sandwiched between the lower electrode film and the upper electrode film in the structure constitutes the vibrating part of the structure, and operates at a predetermined resonance frequency. As one of the methods for manufacturing the FBAR, there is a method in which the structure is formed over the substrate through a sacrificial layer therebetween, then the structure is formed with a hole part or parts reaching the sacrificial layer, and an etchant for the sacrificial layer is supplied through the hole part or parts to remove the sacrificial layer, thereby forming the vibrating space.

In such a process of manufacturing the FBAR, it is recommendable that the hole part or parts for supplying the etchant for the sacrificial layer are large in aperture area and large in the number of apertures, from the viewpoint of supplying the etchant. However, from the viewpoint of securing the strength of the structure provided with the hole part or parts and securing a wide thermal conduction path during operation of the FBAR, the hole part or parts are required to be small in aperture area and small in the number of apertures. In addition, in order to enhance the resonance characteristics of the FBAR, it may be necessary to enlarge the area of the vibrating part of the structure and to enlarge the volume of the vibrating space. Therefore, in connection with the process of manufacturing the FBAR, there is a need for a method in which the sacrificial layer filling the large space is efficiently etched through the small hole part or parts, resulting in the formation of a large space (cavity).

Here, a silicon oxide based material is used for forming the sacrificial layer, and a hydrogen fluoride based etchant is used for the etching. The etching of the sacrificial layer proceeds according to the following reaction formula 1:

[Math 1]

$$\text{dissociating species}$$
$$\downarrow$$
$$4HF + SiO_2 \longrightarrow SiF_4 + 2H_2O \quad \cdots (1)$$

As for the etching of the sacrificial layer, both wet etching and dry etching have been being investigated. For removal of the sacrificial layer by wet etching, the following method has been reported. In the method, first, a sacrificial layer composed of a silicon oxide film is buried in a recess formed in the substrate surface so as to be flat at its upper surface, and then a lower electrode film, a piezoelectric film and an upper electrode film are sequentially layered on the flat upper surface. Thereafter, an aqueous hydrogen fluoride solution is introduced through a hole part or parts provided in the state of penetrating these films. Since both hydrogen fluoride and water as the dissociating species for hydrogen fluoride are introduced, the sacrificial layer is etched away in the condition where hydrogen fluoride is dissociated, whereby the vibrating space is formed and the structure including the lower electrode film, the piezoelectric film and the upper electrode film is formed (refer to, for example, U.S. Patent No. 6,060,818).

Besides, other than the application of the FBAR, a method of manufacturing a micromachine by forming a vibrating space through etching a sacrificial layer by dry etching has been reported, in which the sacrificial layer is removed by dry etching conducted by using a gaseous mixture of a hydrogen fluoride gas and water vapor serving as a dissociating species for hydrogen fluoride (refer to, for example, "Characterization of Residues on Anhydrous HF Gas-Phase Etching of Sacrificial Oxides for Surface Micromachining", Japanese Journal of Applied Physics, January 2000, Vol. 39, Part 1, No. 1, pp. 337 to 342).

However, in the method disclosed in U.S. Patent No. 6,060,818, not only the lower electrode film side of the bridge-like structure but also the upper electrode film side of the structure is exposed to the aqueous hydrogen fluoride solution during when the sacrificial layer is etched away, so that the hydrogen fluoride adsorbed on the lower electrode film and the upper electrode film is desorbed. Therefore, the structure is liable to be corroded during the etching.

In addition, since the aqueous hydrogen fluoride solution is introduced through the hole part or parts of which the aperture area is small and the number of apertures is small, as has been mentioned above, the efficiency of replacement of the aqueous hydrogen fluoride solution introduced into the vibrating space being formed will be poor. Therefore, as the etching of the sacrificial layer proceeds, the amount of the hydrogen fluoride component in the vibrating space is reduced and the etching rate is slowed down extremely.

Furthermore, in order to prevent the structure from being corroded by the hydrogen fluoride component adsorbed thereon after the etching of the sacrificial layer, it may be necessary to perform rinsing for removing the remaining hydrogen fluoride component. However, the replacement of the aqueous hydrogen fluoride solution in the vibrating space with the rinsing water through the hole part or parts is poor in efficiency, and it is difficult to securely remove the remaining hydrogen fluoride component. Therefore, not only the corrosion during the etching-away of the sacrificial layer but also the corrosion on the lower electrode film side of the structure by the remaining hydrogen fluoride component will matter. In addition, where wet etching is conducted and then drying is therefore conducted, the structure may be deformed or broken due to the surface tension of water.

Also where the method of manufacturing a micromachine described in "Characterization of Residues on Anhydrous HF Gas-Phase Etching of Sacrificial Oxides for Surface Micromachining", Japanese Journal of Applied Physics, January 2000, Vol. 39, Part 1, No. 1, pp. 337 to 342 is applied to FBAR, not only the lower electrode film side of the structure but also the upper electrode film side of the structure is exposed to hydrogen fluoride and water vapor serving as the dissociating species for the hydrogen fluoride during when the sacrificial layer is etched away. Therefore, the hydrogen fluoride adsorbed on the lower electrode film side and the upper electrode film side is desorbed, resulting in that the structure is liable to be corroded during the etching.

In addition, depending on the layout of the hole part or parts, the etching residue may remain at a lower part of the vibrating part of the structure which will be the operating region of the FBAR, whereby addition of a mass to the lower electrode film may be generated, worsening the resonance characteristics of the FBAR.

Furthermore, in the case where a treatment is conducted in a heated atmosphere or a reduced-pressure atmosphere in order to remove water present as the reaction product, the water vapor supplied together with the hydrogen fluoride gas so as to serve as the dissociating species for hydrogen fluoride would not be easily adsorbed on the surface of the sacrificial layer. As a result, the etching rate would be lowered.

Disclosure of Invention

In order to solve the above-mentioned problems, a method of manufacturing a micromachine according to the present invention includes the following steps are sequentially carried out. First, in a first step, a sacrificial layer having a silicon oxide based material containing a hydrogen fluoride dissociating species is patternedly formed on a substrate. Next, in a second step, a structure is formed on the substrate in the state of covering the sacrificial layer. Subsequently, in a third step, the structure on the sacrificial layer is formed with a hole part or parts reaching the sacrificial layer. Thereafter, in a fourth step, a vibrating space is formed between the substrate and the structure by introducing only a hydrogen fluoride gas or only the hydrogen fluoride gas and an inert gas through the hole part or parts and etching the sacrificial layer by use of the dissociating species contained in the sacrificial layer.

According to the method of manufacturing a micromachine as just-mentioned, the silicon oxide based material constituting the sacrificial layer contains the hydrogen fluoride dissociating species, so that in the fourth step, only the hydrogen fluoride adsorbed on the surface of the sacrificial layer is dissociated. This ensures that dissociation of hydrogen fluoride does not occur on the upper surface side of the structure being exposed to the treating atmosphere and, therefore, corrosion of the structure is restrained. Therefore, where the structure includes the lower electrode film, the piezoelectric film and the upper electrode film, the resonance characteristics of the vibrating part having the piezoelectric film sandwiched between the lower electrode film and the upper electrode film are prevented from being worsened.

In addition, in the case where the structure includes the lower electrode film, the piezoelectric film and the upper electrode film and where the position or positions of the hole part or parts are so specified in the third step that the end point of the etching will be located on the outside of the area underneath the upper electrode film, the etching residue of the sacrificial layer is prevented from remaining underneath the upper electrode film. This prevents the resonance characteristics from being worsened due to the addition of a mass to the lower electrode film of the vibrating part having the piezoelectric film sandwiched between the lower electrode film and the upper electrode film.

Besides, where the etching in the fourth step is carried out in a heated atmosphere or a reduced-pressure atmosphere, the water as the reaction product of the etching is not liquefied but is efficiently removed from the vibrating space, so that a higher etching rate is secured. In addition, the bridge is prevented from being deformed or broken by the surface tension which might be generated at the time of gasification of liquefied water.

Besides, a micromachine according to the present invention includes a structure provided over a substrate through a vibrating space therebetween, the structure including a lower electrode film, a piezoelectric film, and an upper electrode film sequentially layered in this order, the upper electrode film provided on a substantially central region of the piezoelectric film, and the piezoelectric film and the lower electrode film being formed with a hole part or parts reaching the vibrating space, on the outside of the upper electrode film. The vibrating space is formed by etching away a sacrificial layer provided between the substrate and the lower electrode film, and the hole part or parts are disposed so that the end point of the etching will be located on the outside of the area underneath the upper electrode film.

According to the micromachine as just-mentioned, the hole part or parts formed in the piezoelectric film and the lower electrode film are so located that the end point of the etching of the sacrificial layer will be located on the outside of the area underneath the upper electrode film; therefore, the etching residue of the sacrificial layer is prevented from remaining at a lower part of the vibrating part having the piezoelectric film sandwiched between the lower electrode film and the upper electrode film. This prevents the resonance characteristics of the vibrating part from being worsened.

As has been described above, according to the method of manufacturing a micromachine based on the present invention and the micromachine obtained by the method, corrosion of the structure is restrained, so that where the structure includes the lower electrode film, the piezoelectric film and the upper electrode film, the resonance characteristics of the vibrating part can be prevented from being worsened. This makes it possible to obtain a high-quality micromachine. In addition, where the position or positions of the hole part or parts are so specified that the end point of the etching will be located on the outside of the area underneath the upper electrode film, the etching residue of the sacrificial layer is prevented from remaining at a lower portion of the vibrating part having the piezoelectric film sandwiched between the lower electrode film and the upper electrode film. This also prevents the resonance characteristics of the vibrating part from being worsened.

Further, where the etching of the sacrificial layer is carried out in a heated atmosphere or a reduced-pressure atmosphere, the etching rate is made higher, so that the sacrificial layer with a large volume can be removed through the hole part or parts of which the aperture area is small and the number of apertures is small. This makes it possible to form a micromachine having a large vibrating space, and to enhance the electrical characteristics of the micromachine. Furthermore, with the etching of the sacrificial layer carried out in a heated atmosphere or a reduced-pressure atmosphere, the structure is prevented from being deformed or broken, so that it is possible to obtain a micromachine with an excellent productivity and in a good yield.

Brief Description of Drawings

FIGS. 1(a) to 1(d) are manufacturing step sectional views for illustrating an embodiment of the method of manufacturing a micromachine based on the present invention.
FIGS. 2(a) to 2(c) are plan views for illustrating an embodiment of the method of manufacturing a micromachine based on the present invention.
FIGS. 3(a) to 3(c) are plan views for illustrating an embodiment of the method of manufacturing a micromachine based on the present invention.
FIGS. 4(a) to 4(c) are plan views for illustrating an embodiment of the method of manufacturing a micromachine based on the present invention.
FIGS. 5(a) to 5(c) are plan views for illustrating an embodiment of the method of manufacturing a micromachine based on the present invention.
FIGS. 6(a) to 6(c) are plan views for illustrating an embodiment of the method of manufacturing a micromachine based on the present invention.
FIG. 7 is a block diagram for illustrating an etching apparatus pertaining to the method of manufacturing a micromachine based on the present invention.
FIG. 8 is a graph showing variations in the boiling point of water with pressure and temperature of a treating atmosphere.
FIG. 9 is a sectional view for illustrating an embodiment the method of manufacturing a micromachine, and the micromachine, based on the present invention.

FIGS. 10(a) and 10(b) are manufacturing step sectional views for illustrating an embodiment of the method of manufacturing a micromachine based on the present invention.

FIGS. 11(a) and 11(b) are sectional views for illustrating a modification example 1 of an embodiment of the method of manufacturing a micromachine based on the present invention.

FIG. 12 is a plan view for illustrating a modification example 2 of the embodiment of the method of manufacturing a micromachine based on the present invention.

Best Mode for Carrying out the Invention

Now, an embodiment of the method of manufacturing a micromachine, and the micromachine, based on the present invention will be described in detail below, based on the drawings.

(First Embodiment)

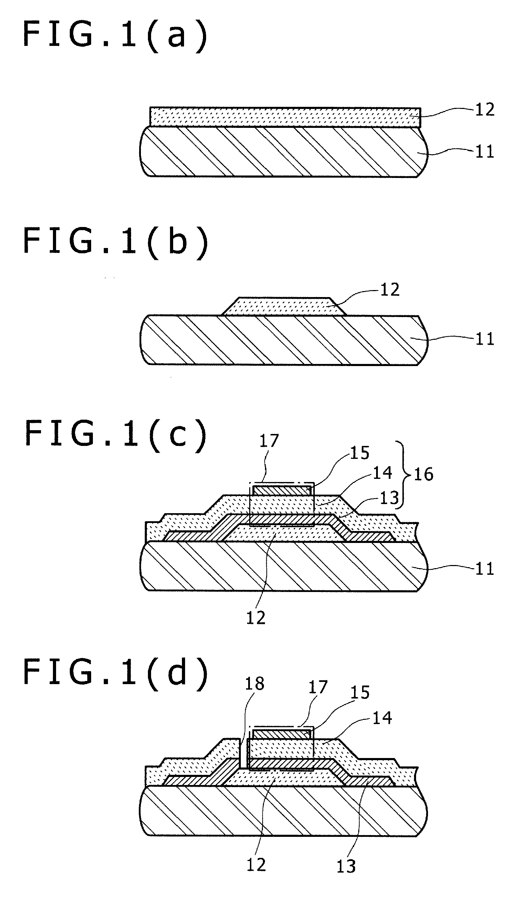

In this embodiment, an example of forming a micromachine including an air bridge type FBAR will be described referring to FIG. 1. Incidentally, the configuration of the micromachine based on the present invention will be described in detail in the order of manufacturing steps.

<Sacrificial Layer Forming Step>

First of all, a sacrificial layer for specifying the shape of a vibrating space is formed. The forming method may be, for example, a method in which as shown in FIG. 1(a), a sacrificial layer 12 containing a dissociating species for hydrogen fluoride to be used as an etching gas in etching conducted in a later step is formed on a substrate 11. Here, the sacrificial layer 12 includes, for example, a SOG (Spin on Glass) film. Here, the SOG film is obtained by dissolving a silicon compound represented generally by $R_nSi(OH)_{4-n}$ or the like in an alcohol-based organic solvent. The organic solvents which can be used include PGDM (propylene glycol dimethyl ether), EGDM (ethylene glycol dimethyl ether), methanol, acetone, and IPA (isopropyl alcohol), which may be used either singly or in mixture of a plurality of them.

After the solution is applied to the substrate 11, sintering is conducted to evaporate the organic solvent, thereby forming a silicon oxide based material layer. Though most of the organic solvent is evaporated by the sintering, a portion of the organic solvent and additives remain in the film. In addition, in the case where the silicon compound $R_nSi(OH)_{4-n}$ is not completely changed into silicon dioxide by the sintering (where most of the silicon compound is changed to silicon dioxide but a portion thereof is not changed to silicon dioxide), hydroxyl groups (OH groups) are remaining. The organic solvent and the OH groups, as dissociating species capable of dissociating hydrogen fluoride, are kept contained in the sacrificial layer 12.

The dissociating species may be contained in the sacrificial layer 12 in any state, and the sacrificial layer 12 may be in a hygroscopic state due to the presence of the dissociating species. In addition, the dissociating species may be in the state of being adsorbed on the surfaces of microporous spaces in the SOG film which is low in film density.

Incidentally, while the organic solvent and the OH groups are contained in the sacrificial layer 12 as the dissociating species for hydrogen fluoride here, water may be contained. For example, where the sacrificial layer 12 is composed of PSG (Phospho Silicate Glass), BPSG (Borophospho Silicate Glass), or silicon oxyfluoride (SiOF), the very high hygroscopicity of the compound results in that the film formed takes in moisture from the atmosphere and the moisture thus taken in serves as a dissociating species for hydrogen fluoride. Where PSG or BPSG is used, however, P (phosphorus) and/or B (boron) is liable to remain as an etching residue, so that a treatment for removing P and/or B would be needed after the etching. In view of this, the sacrificial layer 12 is preferably composed of a SOG film or an SiOF film.

Next, as shown in FIG. 1(b), a resist is applied onto the sacrificial layer 12, and a resist mask (omitted in the figure) is formed by the common photolithography technique. Subsequently, the sacrificial layer 12 is patterned into a desired shape by dry etching conducted by use of the resist mask. As a result, for example, a sacrificial layer 12 which is 100 $\mu$m X 100 $\mu$m in bottom surface shape and 0.5 $\mu$m in height is formed. The volume occupied by the sacrificial layer 12 will be the volume of a vibrating space formed by etching-away in a later step. Thereafter, the resist mask is removed.

<Vibrating Part and Hole Part Forming Step>

Next, as shown in FIG. 1(c), a lower electrode film 13 composed of molybdenum (Mo), for example, is formed in a thickness of 0.3 $\mu$m on the substrate 11 in the state of covering the sacrificial layer 12 by, for example, sputtering. Subsequently, the lower electrode film 13 is patterned into such a shape as to cover the sacrificial layer 12.

Next, for example, a piezoelectric film 14 including aluminum nitride (AlN), for example, is formed in a thickness of, for example, 1 $\mu$m on the substrate 11 in the state of covering the lower electrode film 13 by, for example, sputtering. Then, the piezoelectric film 14 is patterned into such a shape as to cover the lower electrode film 13.

Subsequently, an upper electrode film 15 composed of Mo, for example, is formed in a thickness of 0.3 $\mu$m on the substrate 11 in the state of covering the piezoelectric film 14 by, for example, sputtering. Then, the upper electrode film 15 is patterned so as to be located on a substantially central region of the piezoelectric film 14. As a result, a structure 16 is formed which includes the lower electrode film 13, the piezoelectric film 14 and the upper electrode film 15. The area where the piezoelectric film 14 is sandwiched between the lower electrode film 13 and the upper electrode film 15 will form the vibrating part 17 of the FBAR to be manufactured.

Next, as shown in FIG. 1 (d), the piezoelectric film 14 and the lower electrode film 13 on the outside of the upper electrode film 15, i.e., in other region than the region where the upper electrode film 15 is provided are formed with a hole part or parts 18 reaching the sacrificial layer 12. The hole part or parts 18 will serve as an inlet port or ports for introducing an etching gas for etching of the sacrificial layer 12. The hole part or parts 18 are provided on the outside of the upper electrode film 15, in order to prevent the resonance characteristics of the vibrating part 17 from being worsened due to the presence of the hole part or parts 18. The hole part or parts 18 are preferably small in aperture area and small in the number of apertures, in order to reduce the influence thereof on the vibration of the vibrating part 17 and to enhance thermal conductivity. Here, three hole parts 18 with an aperture diameter of several micrometers, for example, are formed.

Incidentally, while the hole part or parts 18 are formed here in the state of reaching the surface of the sacrificial layer 12, the hole part or parts 18 may be provided in the state of reaching the inside of the sacrificial layer 12. The configuration in which the hole part or parts 18 reach the inside of the sacrificial layer 12 is preferable, from the viewpoint of enlarging the surface area of the sacrificial layer 12 relevant to the adsorption of hydrogen fluoride at the time of starting the etching of the sacrificial layer 12 to be described later.

Here, it is preferable to form the hole part or parts 18 while specifying the position(s) thereof so that the end point of the etching of the sacrificial layer 12 in the subsequent step, i.e., the portion etched last of the sacrificial layer 12 will be located on the outside of the area underneath the upper electrode film 15. This is for preventing the etching residue from remaining at a lower portion of the vibrating part 17, in view of that the etching reaction is liable to be instable at the end point of the etching and that the etching residue of the sacrificial layer 12 is liable to be generated at the end point. Here, the etching end point is defined to be the last etched portion of the sacrificial layer in each of the divided regions in the case where the sacrificial layer region is divided into a plurality of regions as the etching proceeds (namely, the etching end point is not limited to the last etching point on a time lapse basis of the part which has been a single sacrificial layer before the start of the etching). This ensures that, even if the etching residue of the sacrificial layer 12 is generated, the residue is prevented from remaining at a lower portion of the vibrating part 17, so that the resonance characteristics of the vibrating part 17 are prevented from being worsened by an effect of adding a mass to the lower electrode film 13.

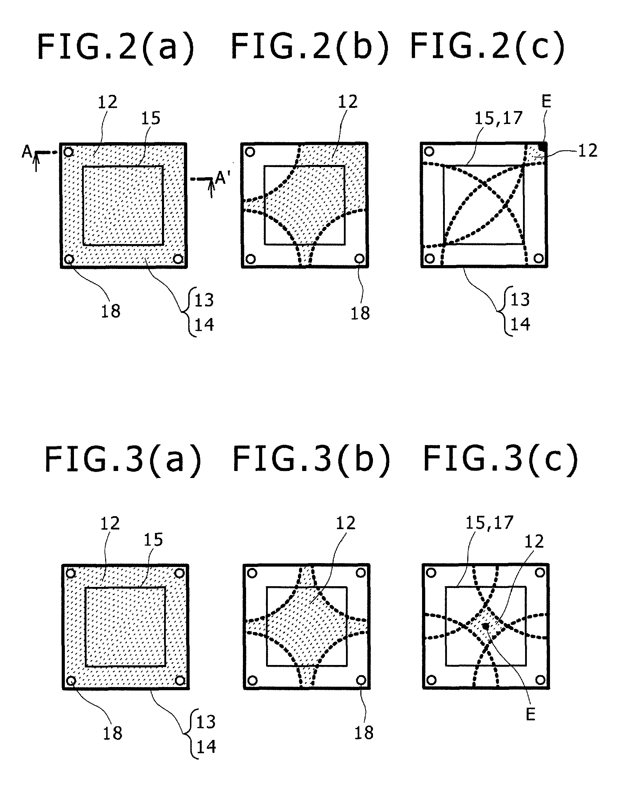

Here, for example, as shown in the plan view in FIG. 2(a), the hole parts 18 are formed at three of the four corners of the lower electrode film 13 and the piezoelectric film 14 on the outside of the area of the upper electrode film 15 on the sacrificial layer 12 provided to be rectangular in plan view. Here, the sectional view in FIG. 1(d) is taken along line A-A' of the plan view. In this case, as shown in FIG. 2(b), the etching of the sacrificial layer 12 proceeds isotropically from the hole parts 18. Then, as shown in FIG. 2(c), the end point E of etching is the one, where the hole part 18 is not provided, of the above-mentioned four corners, and the end point E is located on the outside of the area underneath the upper electrode film 15, i.e., on the outside of the vibrating part 17.

Here, FIG. 3(a) shows an example in which the hole parts 18 are provided at all the four corners of the lower electrode film 13 and the piezoelectric film 14 on the outside of the area of the upper electrode film 15. In this case, as shown in FIG. 3(b), the etching of the sacrificial layer 12 proceeds isotropically from the hole parts 18, whereon the end point E of the etching of the sacrificial layer 12 will be located underneath the upper electrode film 15, as shown in FIG. 3(c). As a result, the etching residue is liable to remain at a lower portion of the vibrating part 17, thereby worsening the resonance characteristics of the vibrating part 17.

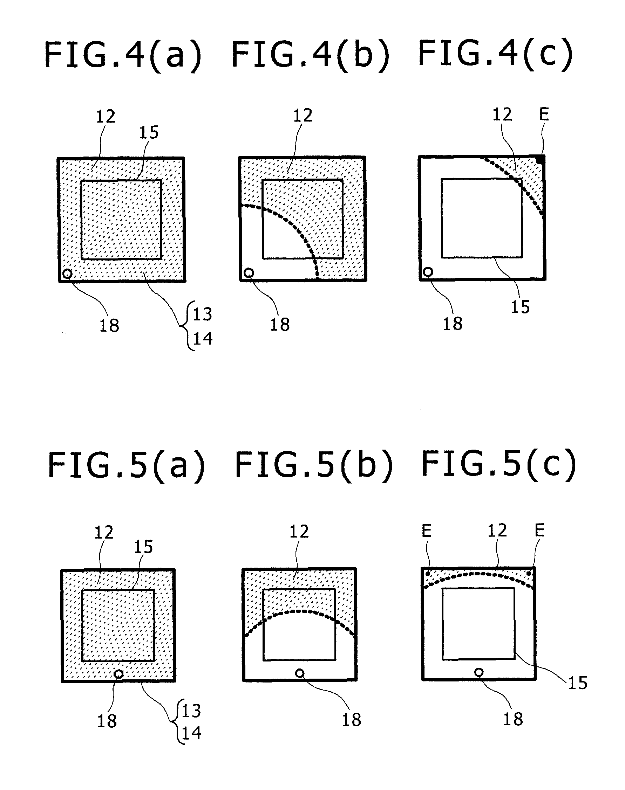

Besides, in the case where the etching rate in the etching described later is high, only one hole part 18 may be formed, as shown in FIG. 4(a). In this case, also, the position of the hole part 18 is so specified that the end point E of etching of the sacrificial layer 12 will be located on the outside of the area underneath the upper electrode film 15. For example, where the lower electrode film 13 and the piezoelectric film 14 over the sacrificial layer 12 are provided with the hole part 18 at one of the four corners thereof, the etching of the sacrificial layer 12 proceeds isotropically from the hole part 18, as shown in FIG. 4(b), whereon the end point E of the etching is located on the outside of the area underneath the upper electrode film 15, specifically, located at a position diagonally opposite to the hole part 18, as shown in FIG. 4(c).

In the case where the hole part 18 is formed at a central portion of an edge constituting the plan-view shape of the lower electrode film 13 and the piezoelectric film 14 over the sacrificial layer 12, as shown in FIG. 5(a), the etching of the sacrificial layer 12 proceeds isotropically from the hole part 18 as shown in FIG. 5(b), whereon the end points E of etching are located on the outside of the area of the upper electrode film 15, specifically, located at the two corners of the edge opposite to the hole part 18, as shown in FIG. 5(c). In this case, the etching residue remains at two locations, but this does not matter insofar as the two locations are outside the area underneath the upper electrode film 15.

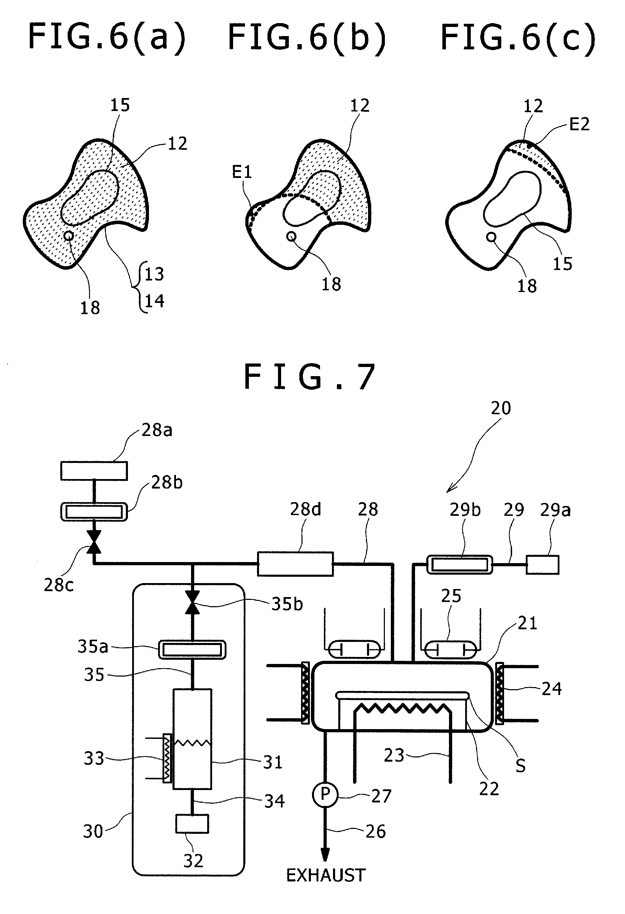

Further, as shown in FIG. 6(a), the shape of the sacrificial layer 12 is not limited to the rectangular shape in plan view. In this case, also, the position of the hole part 18 is so specified that, even when the etching of the sacrificial layer 12 proceeds isotropically from the hole part 18 and the unetched region of the sacrificial layer 12 is divided into two regions in the course of etching as shown in FIG. 6(b), the end points of etching in the respective regions of the sacrificial layer 12, namely, the end points E1 and E2 are located on the outside of the area underneath the upper electrode film 15, as shown in FIGS. 6(b) and 6(c).

<Etching Apparatus>

Now, an etching apparatus used for etching of the sacrificial layer will be described below. Here, the etching apparatus will be described referring to FIG. 7.

As shown in FIG. 7, the etching apparatus 20 includes a treating chamber 21 for treating a substrate to be treated. In the treating chamber 21, a stage 22 for supporting the substrate S mounted thereon is disposed at a bottom portion, for example. The stage 22 is fitted with a temperature controller 23 so that the substrate S mounted on the stage 22 can be heated.

In addition, a temperature controller 24 such as a heater and an infrared ray lamp 25 are disposed on the outer wall side of the treating chamber 21, for the purpose of eliminating a temperature gradient in the treating atmosphere and facilitating temperature control. This prevents the temperature and pressure of the etching gas in the treating atmosphere from being varied, and prevents the treating chamber 21 from being corroded due to dewing or adsorption of a large amount of the etching gas. Besides, though omitted in the figure, a preparatory chamber is provided adjacent to the treating chamber 21; in the case of feeding the substrate to be treated (substrate S) into the treating chamber 21, the substrate S is desirably introduced into the treating chamber 21 through the preparatory chamber so as to prevent the atmospheric air from entering into the treating chamber 21.

An exhaust pipe 26 for removing the surplus etching gas and the reaction products upon etching is connected, for example, to the lower side of the treating chamber 21. The exhaust pipe 26 is equipped with a vacuum pump 27 and a pressure control valve (omitted in the figure) so that the pressure of the atmosphere in the treating chamber 21 can be reduced.

In addition, one-side ends of an etching gas supply pipe 28 and a purge gas supply pipe 29 for supplying gases into the treating chamber 21 are connected, for example, to the upper side of the treating chamber 21. Incidentally, though omitted in the figure, a tip part of the etching gas supply pipe 28 is provided, for example, in the shape of a shower head so that the etching gas can be supplied toward the whole area of the substrate S mounted on the stage 22 in the treating chamber 21.

On the other hand, the other-side end of the etching gas supply pipe 28 is connected to a cylinder 28a reserving a carrier gas including an inert gas. Here, in the present invention, the inert gas contains nitrogen gas. In addition, the etching gas supply pipe 28 is fitted with a flow rate controller 28b for controlling the flow rate of the carrier gas, a valve 28c, and a temperature controller 28d for controlling the temperature of the gas being supplied, in this order along the course from the cylinder 28a toward the treating chamber 21.

In addition, a hydrogen fluoride gas supply unit 30 for supplying a hydrogen fluoride gas (anhydrous hydrofluoric acid gas) serving as an etching gas is provided between the valve 28c and the temperature controller 28d. The hydrogen fluoride gas supply unit 30 includes a reservoir tank 31 in which hydrogen fluoride is reserved in its liquid state, and a cylinder 32 in which an inert gas (containing nitrogen gas) is reserved. A temperature controller 33 is provided on the outer wall side of the reservoir tank 31 so that the inside of the reservoir tank 31 can be heated. The liquid hydrogen fluoride is bubbled by the inert gas introduced from the cylinder 32 into the reservoir tank 31 through a piping 34, and the gasified hydrogen fluoride is supplied into a piping 35.

The reservoir tank 31 and the etching gas supply pipe 28 are connected to each other through the piping 35. The piping 35 is fitted with a flow rate controller 35a and a valve 35b in this order from the reservoir tank 31 side, and the hydrogen fluoride gas is supplied through them into the etching gas supply pipe 28.

In addition, the other-side end of the purge gas supply pipe 29 is connected to a cylinder 29a in which a purge gas including an inert gas (containing nitrogen gas) is reserved, and the purge gas is introduced into the treating chamber 21 through a flow rate controller 29b.

Incidentally, while an example of a sheet fed type etching apparatus 20 has been described here, any etching apparatus, such as a batch type etching apparatus, that can control the pressure and temperature of the treating atmosphere and can perform a uniform treatment may be used; further, a hot wall type etching apparatus capable of evenly heating the inside of the treating space may also be used.

<Sacrificial Layer Etching Step>

Now, a step of etching the sacrificial layer 12 (see FIG. 1(d)) containing a dissociating species for hydrogen fluoride will be described below. First, the temperature and pressure of the treating atmosphere used for etching are specified. Here, the etching of the sacrificial layer 12 takes place according to the following reaction formula 2:

[Math 2]

$$\text{dissociating species}$$
$$\downarrow$$
$$4HF + SiO_2 \longrightarrow SiF_4 + 2H_2O \quad \cdot \cdot \cdot (2)$$

Of $SiF_4$ and $H_2O$ (water) which are the reaction products of the etching reaction, if the water remains in side the vibrating space to be formed and is liquefied, the structure to be formed in the later step may be deformed or broken by the surface tension of the water at the time of drying. Therefore, the etching of the sacrificial layer 12 is preferably carried out in a treating atmosphere low in water partial pressure so that the water is removed in its gasified state without liquefaction.

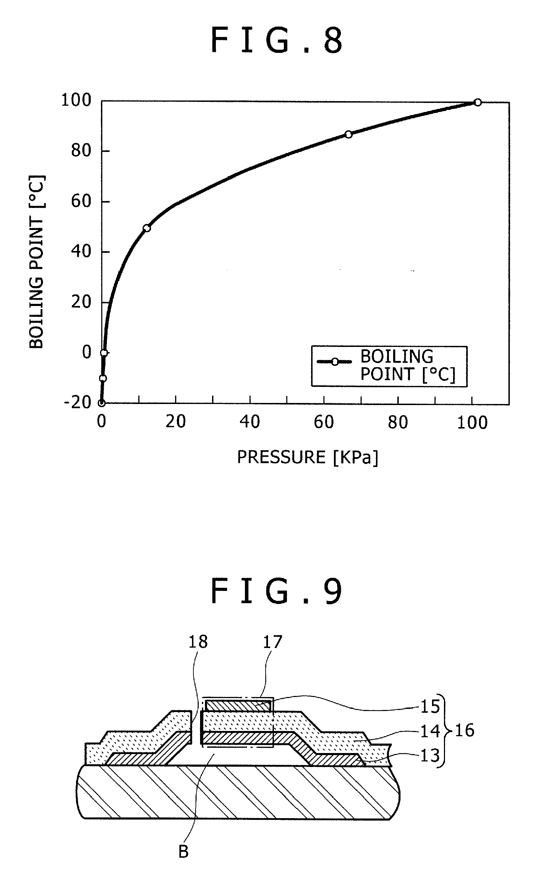

Accordingly, the lower limit of the treating temperature at the treating pressure is so controlled to be not lower than the boiling point of water. Here, FIG. 8 shows a graph of variations in the boiling point of water with temperature and pressure. Liquefaction of water can be prevented when the temperature and pressure of the treating atmosphere are on the upper side of the graph.

Here, for specifically determining the treating temperature and the treating pressure, the results of preparatory tests in the case where a SOG film is used as the sacrificial layer 12 and where the treating temperature is varied in the range of 25 to 250°C and the treating pressure is varied in the range of 0.01 to 100 kPa are shown in Table 1 below.

[Table 1]

| Pressure of treating atmosphere [kPa] | 25 | 50 | 75 | 100 | 125 | 150 | 175 | 200 | 225 | 250 |
|---|---|---|---|---|---|---|---|---|---|---|
| 100 | × | × | × | × | × | × | × | × | × | × |
| 50 | × | ○ | ○ | ○ | ○ | ○ | ○ | ○ | ○ | ○ |
| 30 | × | ○ | ◎ | ◎ | ◎ | ◎ | ◎ | ◎ | ○ | ○ |
| 10 | × | ○ | ◎ | ◎ | ◎ | ◎ | ◎ | ◎ | ○ | ○ |
| 5 | × | ○ | ○ | ○ | ○ | ○ | ○ | ○ | ○ | ○ |
| 1 | × | ○ | ○ | ○ | ○ | ○ | ○ | ○ | ○ | ○ |
| 0.1 | × | × | × | × | × | × | × | × | × | × |
| 0.01 | × | × | × | × | × | × | × | × | × | × |

Temperature of treating atmosphere [°C]

Here, symbols ◎ and ○ shown in Table 1 indicate that the etching proceeds without any problem, while symbol × indicates that some problem exists in the etching conditions. As shown in the table, the temperature range (○) in which the etching of the sacrificial layer 12 proceeds without any problem is 50 to 250°C, and a further optimum range is 75 to 200°C (◎). If the treating temperature is lower than 50°C, water may be liquefied since the heat for evaporation is not supplied even at a treating temperature above the boiling point of water in the reduced-pressure atmosphere. On the other hand, if the treating temperature exceeds 250°C, the hydrogen fluoride gas would not easily be adsorbed on the surface of the sacrificial layer 12, so that the etching rate would be low. Therefore, the etching is conducted in a heated atmosphere at a temperature of 50 to 250°C, whereby liquefaction of water can be prevented, and a high etching rate can be obtained.

In addition, the pressure range in which the etching of the sacrificial layer 12 proceeds without any problem is 1 to 50 kPa, and a further optimum range is 10 to 30 kPa. If the pressure of the treating atmosphere is less than 1 kPa, the partial pressure of the hydrogen fluoride would be low, so that hydrogen fluoride would not be easily desorbed on the surface of the sacrificial layer 12, and the etching rate would be low. On the other hand, if the treating pressure is above the normal pressure (100 kPa), the mean free paths of hydrogen fluoride and the reaction products ($SiO_4$, $H_2O$) would be short, and the efficiency of replacement of gases through the hole parts 18 (see FIG. 1(d)) would be low. Therefore, the etching is carried out in the reduced-pressure atmosphere at a pressure of 1 to 50 kPa, whereby a high etching rate is secured, and the gas replacement efficiency is enhanced. Here, for example, the temperature of the treating atmosphere is set to 150°C, and the pressure of the treating atmosphere is set to about 25 kPa.

Then, the substrate 11 (substrate S) with the lower electrode film 13 and the piezoelectric film 14 formed with the hole part or parts 18 reaching the sacrificial layer 12 as described referring to FIG. 1(d) above is introduced into the treating chamber 21 of the etching apparatus 20 as described referring to FIG. 7 above. Next, the substrate S is mounted and supported on the stage 22, and the temperature of the substrate S is raised to the treating temperature (100°C) by the temperature controller 23. In addition, the temperature in the treating chamber 21 is controlled to the treating temperature by the temperature controller 24 and the infrared ray lamp 25.

In addition, the pressure inside the treating chamber 21 is controlled to the treating pressure (25 kPa) of the reduced-pressure atmosphere by the vacuum pump 27 and the pressure control valve (omitted in the figure) provided for the exhaust pipe 26. When the predetermined temperature and the predetermined pressure are attained in the treating chamber 21, the hydrogen fluoride gas (anhydrous hydrofluoric acid gas) and the carrier gas including the inert gas are supplied through the etching gas supply pipe 28 at a flow rate of 500 cm³/min, for example. The flow rate of the etching gas is determined by taking into account the volume of the sacrificial layer 12, the size of the treating chamber 21, and uniformity of the treatment. The temperature of hydrogen fluoride supplied is desirably controlled to be equal to the temperature of the treating atmosphere by the temperature controller 28d.

Incidentally, while the hydrogen fluoride gas is supplied here together with the carrier gas, the hydrogen fluoride gas alone may be supplied. Besides, in the case where the controllability of the pressure in the treating chamber 21 is worsened by the abrupt flow of the etching gas at the time of starting the treatment, it is desirable to adopt a method in which the carrier gas is preliminarily fed at a flow rate equal to the flow rate of the etching gas fed during the treatment, thereby controlling the pressure in the treating chamber 21 to the treating pressure, and thereafter the carrier gas thus fed is replaced by the etching gas at the time of starting the treatment.

As a result, as shown in FIG. 9, the hydrogen fluoride gas is introduced through the hole part or parts 18 provided in the lower electrode film 13 and the piezoelectric film 14. When hydrogen fluoride is adsorbed on the surface of the sacrificial layer 12 (see FIG. 1(d)), the hydrogen fluoride is dissociated through reaction with the dissociating species, such as the solvent and hydroxyl groups, contained in the sacrificial layer 12. Then, by the hydrogen fluoride thus dissociated, the sacrificial layer 12 including a silicon oxide film is etched away. In this case, water and $SiF_4$ as the etching reaction products are evaporated in the reduced-pressure and heated atmosphere, and the mean free paths of the gases are increased due to the reduced-pressure and heated atmosphere, so that the water and $SiF_4$ are discharged into the inside of the treating chamber 21 through the hole part or parts 18. Further, the water and $SiF_4$ are discharged from the inside of the treating chamber 21 by the vacuum pump 27.

Thereafter, when the sacrificial layer 12 is removed, the supply of the etching gas is stopped. As a result, the vibrating space B is formed between the substrate 11 and the structure 16. In addition, the structure 16 including the lower electrode film 13, the piezoelectric film 14 and the upper electrode film 15 is provided in a box-like shape covering the vibrating space B, and the vibrating space B and the space on the outside of the structure 16 communicate with each other only through the hole part or parts 18.

Next, in order to discharge the etching gas and the reaction products from the inside of the treating chamber 21 and the inside of the vibrating space B, the pressure inside the treating chamber 21 is further lowered to discharge the gases through the exhaust pipe 26. If necessary, a purge gas may be introduced through the purge gas supply pipe 29 into the treating chamber 21, thereby replacing the gases present in the treating chamber 21 and the vibrating space B. Besides, the pressure inside the treating chamber 21 may be changed to change the density of the gases, thereby replacing the gasses present in the treating chamber 21 and the vibrating space B. Further, the temperature of the substrate 11 may be further raised by the temperature controller 23 provided for the stage 22, thereby permitting the hydrogen fluoride component adsorbed to be easily desorbed. Thereafter, an atmosphere at the atmospheric pressure is provided in the treating chamber 21, and the substrate 11 of which the treatment is finished is fed out of the treating chamber 21. In this manner, an air bridge type FBAR is fabricated.

According to the method of manufacturing a micromachine as above-described and the micromachine obtained by the method, the SOG film constituting the sacrificial layer 12 contains the dissociating species for hydrogen fluoride, so that the supply of only the hydrogen fluoride gas and the carrier gas leads to the desorption of only hydrogen fluoride adsorbed on the surface of the sacrificial layer 12. This ensures that desorption of hydrogen fluoride does not occur on the side of the surface of the structure 16 exposed to the treating temperature, so that corrosion of the structure 16 is restrained. As a result, the resonance characteristics of the vibrating part 17 having the piezoelectric film 14 sandwiched between the lower electrode film 13 and the upper electrode film 15 are prevented from being worsened.

In addition, as has been described referring to FIG. 2 above, the position(s) of the hole part or parts 18 for introducing the etching gas are so specified that the end point E of the etching of the sacrificial layer 12 will be located on the outside of the area underneath the upper electrode film 15. Therefore, even where the residue is generated upon the etching of the sacrificial layer 12, the etching residue is prevented from remaining underneath the upper electrode film 15. This also contributes to prevention of the resonance characteristics of the vibrating part 17 from being worsened.

Further, since the etching of the sacrificial layer 12 is carried out in a heated atmosphere and/or in a reduced-pressure atmosphere, water as an etching reaction product is not liquefied but is removed efficiently from the vibrating space B, so that a high etching rate is secured. This ensures that the sacrificial layer 12 with a large volume can be removed through the hole part or parts 18 small in aperture area and small in the number of apertures. As a result, it is possible to fabricate an FBAR with a large vibrating space B and to enhance the characteristics of the FBAR. Further, the raised etching rate makes it possible to make the hole part or parts 18 smaller in aperture area and in the number of apertures, so that a high degree of freedom in the structure of FBAR and a high degree of freedom in layout can be ensured.

Further, by conducting the etching in a heated atmosphere and in a reduced-pressure atmosphere, the water produced inside the vibrating space B can be efficiently evaporated to gas and be prevented from liquefaction, the structure 16 can be prevented from being deformed, cracked or broken due to the surface tension of water. In addition, the etching in the heated atmosphere and in the reduced-pressure atmosphere ensures that hydrogen fluoride is little adsorbed on the structure 16 and little hydrogen fluoride remains; therefore, corrosion due to the remaining hydrogen fluoride is prevented, without a liquid treatment such as pure water rinsing.

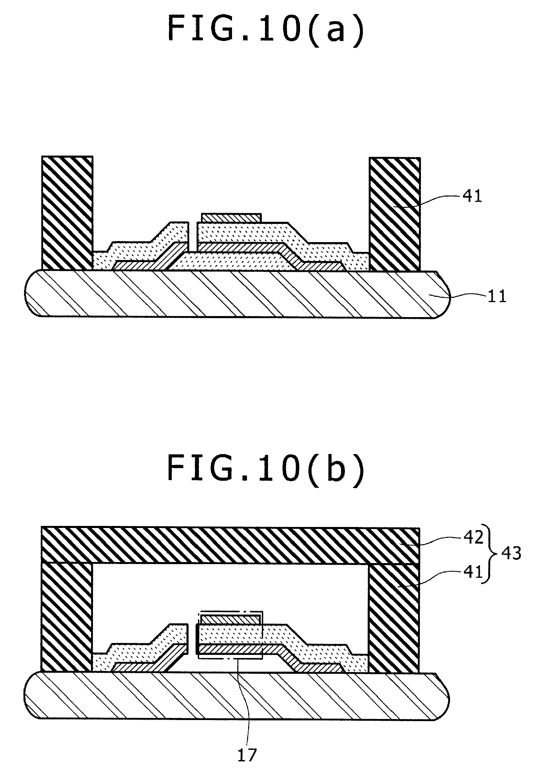

Incidentally, in the above embodiments, the silicon oxide based material containing a hydrogen fluoride dissociating species is used for forming the sacrificial layer 12. Therefore, an etching selectivity ratio can be secured in relation to oxides not containing any hydrogen fluoride dissociating species, such as a thermal silicon oxide formed by a heat treatment, silicon oxide formed by CVD, a TEOS oxide and the like. Accordingly, after the upper electrode film 15 is formed as described referring to FIG. 1(c) above, struts 41 includes a silicon oxide based material not containing any dissociating species may be formed on the substrate 11 in the manner of surrounding the outer periphery of the piezoelectric film 14, as shown in FIG. 10(a). In this case, even in the step of etching away the sacrificial layer 12, the struts 41 can be left un-etched, since the hydrogen fluoride dissociating species is contained only in the sacrificial layer 12. Thereafter, as shown in FIG. 10(b), a cap 42 is formed to cover the top face side of the struts 41, so as to form a seal body 43 includes the struts 41 and the cap 42, whereby an FBAR can be sealed in the condition where a space is provided also on the upper side of the vibrating part 17.

In addition, a layer insulating film for insulation between wirings may be formed by use of a silicon oxide based material not containing any hydrogen fluoride dissociating species, whereby it is possible to make three-dimensional the laying-around of wirings for the FBAR or to use the film as a passivation film. It is to be noted in this case, however, that the film should be spaced by some distance from the sacrificial layer 12 including the silicon oxide based material containing the dissociating species.

(Modification Example 1)

While an example in which the sacrificial layer 12 includes the silicon oxide based material containing the hydrogen fluoride dissociating species has been described in the embodiments above, a silicon oxide based material containing a hydrogen fluoride dissociating species and a silicon oxide based material not containing such a dissociating species may be used in mixture for forming the sacrificial layer 12. In an example of this case, the coating solution used for forming the SOG film may contain, mixed therein, particulates of silicon oxide not containing any hydrogen fluoride dissociating species. In this case, the hydrogen fluoride deposited on the surface of the SOG film is dissociated by the hydrogen fluoride dissociating species in the SOG film, whereby the SOG film is etched, and the etching reaction triggers etching of the particulates of the silicon oxide. As a result, the particulates of silicon oxide higher in mechanical strength and smaller in volume reduction upon a heat treatment as compared with the SOG film are contained in the sacrificial layer 12, whereby the sacrificial layer 12 itself is enhanced in mechanical strength and lessened in volume reduction. Accordingly, the sacrificial layer 12 is prevented from being easily deformed by a film formation stress or a heating treatment during the process of forming the structure 16 by sequentially layering the lower electrode film 13, the piezoelectric film 14 and the upper electrode film 15 over the sacrificial layer 12.

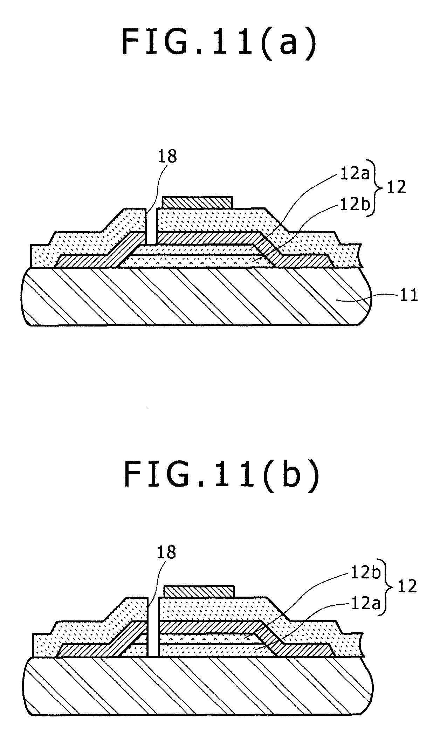

In addition, as shown in FIG. 11(a), the sacrificial layer 12 may have a laminate structure includes two or more layers including a first silicon oxide based material layer (SiO-based material layer) 12a containing a hydrogen fluoride dissociating species and a silicon oxide based material layer (SiO-based material layer) 12b not containing any hydrogen fluoride dissociating species. For example, a second SiO-based material layer 12b includes a silicon oxide film not containing the dissociating species may be formed on a substrate 11 by CVD, and then a first SiO-based material layer 12a includes a SOG film containing the dissociating species may be formed on the second SiO-based material layer 12b, to form a sacrificial layer 12. This ensures that, even in the case where it is desired to form the sacrificial layer 12 in a large thickness and where a sufficient film thickness cannot be obtained by only forming the SOG film, formation of a lower layer of $SiO_2$ by CVD makes it possible to form a sufficiently thick sacrificial layer 12, to enlarge the height of the vibrating space B and to enlarge the volume of the vibrating space B.

In this case, in the step of etching the sacrificial layer 12, the hydrogen fluoride adsorbed on the second SiO-based material layer containing the dissociating species on the upper layer side of the sacrificial layer 12 is dissociated by the dissociating species, whereby the first SiO-based material layer 12a is etched. Then, this etching reaction triggers exposing and etching-away of the second Sio-based material layer 12b present as the lower layer.

Incidentally, while the first SiO-based material layer 12a containing the hydrogen fluoride dissociating species is here laminated on the second SiO-based material layer 12b not containing any hydrogen fluoride dissociating species, the second SiO-based material layer 12b may be laminated on the first SiO-based material layer 12a as shown in FIG. 11(b). It is to be noted in this case, however, that in the step of forming the hole part or parts 18 described referring to FIG. 1(d) in the embodiment above, the hole part or parts 18 are formed in the state of reaching the first SiO-based material layer 12a containing the dissociating species and present on the lower layer side. As a result, the hydrogen fluoride adsorbed on the surface of the first SiO-based material layer 12a is dissociated by the dissociating species. Then, this etching reaction triggers etching-away of the second SiO-based material layer 12b present as the upper layer.

In addition, the sacrificial layer 12 may include three or more layers. In this case, the first SiO-based material layer containing the hydrogen fluoride dissociating species is provided in the state of being exposed at side walls or bottom surfaces of the hole part or parts 18.

(Modification Example 2)

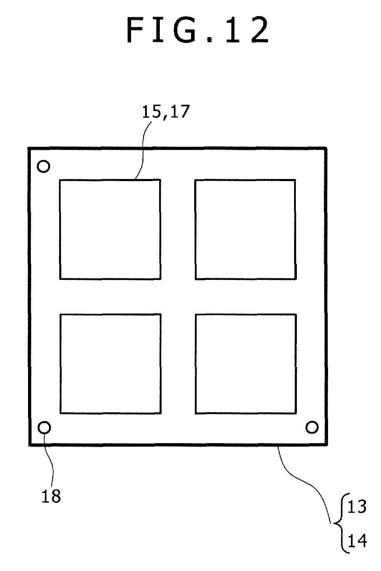

Besides, as shown in FIG. 12, a configuration may be adopted in which the upper electrode film 15 on the piezoelectric film 14 is formed in a plurality of patterns, to thereby form a plurality of vibrating parts 17 each having the piezoelectric film 14 sandwiched between the lower electrode film 13 and the upper electrode film 15. In this case, also, the lower electrode film 13 and the piezoelectric film 14 in other region than the regions where the upper electrode film 15 is provided are formed with a hole part or parts 18 reaching the sacrificial layer 12. Incidentally, the respective shapes of the vibrating parts 17 and the spacing between the vibrating parts 17 specified by the shape of the upper electrode films 15 are appropriately specified according to the resonance frequency and the like factors. Also an FBAR thus configured can be manufactured by the method of manufacturing a micromachine based on the present invention, since the etching rate of the sacrificial layer 12 can be enhanced and, hence, a large vibrating space can be formed.

**Claims**

1.  A method of manufacturing a micromachine comprising:

    a first step of patterningly forming a sacrificial layer including a silicon oxide based material containing a hydrogen fluoride dissociating species on a substrate;
    a second step of forming a structure on said substrate in the state of covering said sacrificial layer;
    a third step of providing said structure on said sacrificial layer with a hole part or parts reaching said sacrificial layer; and
    a fourth step of forming a vibrating space between said substrate and said structure by introducing only a hydrogen fluoride gas or only said hydrogen fluoride gas and an inert gas through said hole part, and etching said sacrificial layer by use of said dissociating species contained in said sacrificial layer.

2.  A method of manufacturing a micromachine as set force in claim 1,
    wherein in said second step, a lower electrode film and a piezoelectric film are sequentially layered over said substrate, and then an upper electrode film is formed on a substantially central region of said piezoelectric film to thereby form said structure including said lower electrode film, said piezoelectric film and said upper electrode film; and
    in said third step, said piezoelectric film and said lower electrode film in other region than the region where said upper electrode film is provided are formed with said hole part or parts reaching said sacrificial layer while specifying the position(s) of said hole part or parts so that the end point of said etching will be located on the outside of the area underneath said upper electrode film.

3.  A method of manufacturing a micromachine as set forth in claim 1, wherein said sacrificial layer is comprised of a SOG film.

**4.** A method of manufacturing a micromachine as set forth in claim 1, wherein the number of said hole part or parts is one.

**5.** A method of manufacturing a micromachine as set forth in claim 1, wherein in said fourth step, said etching is conducted in a heated atmosphere or in a reduced-pressure atmosphere so that the reaction product or products of said etching are gasified.

**6.** A method of manufacturing a micromachine as set forth in claim 5, wherein in said fourth step, said etching is conducted by controlling the temperature in said treating atmosphere to within the range of 50 to 250˚C.

**7.** A method of manufacturing a micromachine as set forth in claim 5, wherein in said fourth step, said etching is conducted by controlling the pressure in said treating atmosphere to within the range of 1 to 50 kPa.

**8.** A method of manufacturing a micromachine as set forth in claim 1, wherein said sacrificial layer is formed through mixing a silicon oxide based material containing said dissociating species with a silicon oxide based material not containing said dissociating species.

**9.** A method of manufacturing a micromachine as set forth in claim 1, wherein said sacrificial layer is a laminate structure of a silicon oxide based material layer containing said dissociating species and a silicon oxide based material layer not containing said dissociating species.

**10.** A method of manufacturing a micromachine as set forth in claim 1,
wherein in said second step, a plurality of said upper electrode films are patternedly formed on said piezoelectric film; and
in said third step 3, said piezoelectric film and said lower electrode film in other region than the regions where said plurality of upper electrode films are provided are formed with said hole part or parts.

**11.** A method of manufacturing a micromachine as set forth in claim 1, wherein said micromachine is a thin film bulk acoustic resonator.

**12.** A micromachine comprising a structure provided over a substrate through a vibrating space therebetween, said structure including a lower electrode film, a piezoelectric film, and an upper electrode film sequentially layered in this order, said upper electrode film provided on a substantially central region of said piezoelectric film, and said piezoelectric film and said lower electrode film being formed with a hole part or parts reaching said vibrating space, in other region than the region where said upper electrode film is provided,
wherein said vibrating space is formed by etching away a sacrificial layer provided between said substrate and said lower electrode film, and said hole part or parts are disposed so that the end point of said etching will be located on the outside of the area underneath said upper electrode film.

**13.** The micromachine as set forth in claim 12, wherein said structure is so provided that said vibrating space and a space on the outside of said structure communicate with each other through said hole part or parts.

**14.** The micromachine as set forth in claim 12, wherein the number of said hole part or parts is one.

**15.** The micromachine as set forth in claim 12, wherein a plurality of said upper electrode films are disposed over said piezoelectric film.

**16.** The micromachine as set forth in claim 12, wherein said micromachine is a thin film bulk acoustic resonator.

FIG.1(a)

FIG.1(b)

FIG.1(c)

FIG.1(d)

FIG.2(a)  FIG.2(b)  FIG.2(c)

FIG.3(a)  FIG.3(b)  FIG.3(c)

# FIG.4(a) FIG.4(b) FIG.4(c)

# FIG.5(a) FIG.5(b) FIG.5(c)

EP 1 890 379 A1

FIG.6(a)  FIG.6(b)  FIG.6(c)

FIG.7

EXHAUST

17

# FIG.8

# FIG.9

# FIG.10(a)

41

11

# FIG.10(b)

42
43
41

17

# FIG.11(a)

# FIG.11(b)

# FIG.12

## INTERNATIONAL SEARCH REPORT

| | International application No. |
|---|---|
| | PCT/JP2006/300709 |

A. CLASSIFICATION OF SUBJECT MATTER
*H03H3/02*(2006.01), *H01L41/22*(2006.01), *H01L21/302*(2006.01), *H01L41/09*
(2006.01), *H03H9/17*(2006.01), *B81C1/00*(2006.01)

According to International Patent Classification (IPC) or to both national classification and IPC

B. FIELDS SEARCHED

Minimum documentation searched (classification system followed by classification symbols)
*H03H3/02*(2006.01), *H01L41/22*(2006.01), *H01L21/302*(2006.01), *H01L41/09*
(2006.01), *H03H9/17*(2006.01), *B81C1/00*(2006.01)

Documentation searched other than minimum documentation to the extent that such documents are included in the fields searched
  Jitsuyo Shinan Koho          1922-1996    Jitsuyo Shinan Toroku Koho    1996-2006
  Kokai Jitsuyo Shinan Koho    1971-2006    Toroku Jitsuyo Shinan Koho    1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A<br>X<br>Y | JP 2002-140075 A  (Agilent Technologies Inc.),<br>17 May, 2002 (17.05.02),<br>Par. Nos. [0020], [0037]; Fig. 10<br>& US 6384697 B1         & GB 2367436 A<br>& DE 10119442 A | 1-11<br>12-14,16<br>15 |
| Y | JP 09-64683 A  (Motorola, Inc.),<br>07 March, 1997 (07.03.97),<br>Full text; Figs. 5, 8<br>& US 5692279 A1         & CN 1148291 A | 15 |
| A | JP 2001-129798 A  (Robert Bosch GmbH.),<br>15 May, 2001 (15.05.01),<br>Par. Nos. [0003] to [0019]<br>& EP 1181093 A2         & DE 19941042 A | 1-11 |

☐ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 25 April, 2006 (25.04.06) | 16 May, 2006 (16.05.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**REFERENCES CITED IN THE DESCRIPTION**

**Patent documents cited in the description**

- US 6060818 A

**Non-patent literature cited in the description**

- Characterization of Residues on Anhydrous HF Gas-Phase Etching of Sacrificial Oxides for Surface Micromachining. *Japanese Journal of Applied Physics,* January 2000, vol. 39 (1), 337-342